Europäisches Patentamt

European Patent Office

Office européen des brevets

(19)

(11) Numéro de publication: **0 169 754**
**B1**

# (12) FASCICULE DE BREVET EUROPEEN

(45) Date de publication du fascicule du brevet:
**11.05.88**

(21) Numéro de dépôt: **85401210.1**

(22) Date de dépôt: **18.06.85**

(51) Int. Cl.⁴: **G 01 R 19/165**, G 11 C 19/28,
H 01 L 29/78, H 03 F 3/70,
H 03 K 3/353, G 01 R 29/24

(54) **Comparateur analogique à transfert de charge, et dispositifs utilisant un tel comparateur.**

(30) Priorité: **26.06.84 FR 8410047**

(43) Date de publication de la demande:
**29.01.86 Bulletin 86/5**

(45) Mention de la délivrance du brevet:
**11.05.88 Bulletin 88/19**

(84) Etats contractants désignés:
**DE GB NL**

(56) Documents cités:
**EP - A - 0 147 600**

**IBM TECHNICAL DISCLOSURE BULLETIN, vol. 22, no. 7, décembre 1979, pages 2978-2979, New York, US; L.M. TERMAN et al.: "CCD multilevel storage detection scheme"**
**IBM TECHNICAL DISCLOSURE BULLETIN, vol. 20, no. 5, octobre 1977, pages 2072-2073, New York, US; L.G. HELLER et al.: "High speed, high sensitivity CCD comparator"**
**IBM TECHNICAL DISCLOSURE BULLETIN, vol. 21, no. 3, août 1978, pages 1262-1263, New York, US; L.M. TERMAN et al.: "High sensitivity charge comparator for sensing and comparing very small charge packets"**

(73) Titulaire: **THOMSON-CSF, 173, Boulevard Haussmann, F-75379 Paris Cédex 08 (FR)**

(72) Inventeur: **Berger, Jean-Luc, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 19, avenue de Messine, F-75008 Paris (FR)**

## Description

La présente invention concerne un comparateur analogique à transfert de charge.

Dans certaines applications utilisant des dispositifs à transfert de charge, il est parfois nécessaire de comparer deux quantités de charge entre elles. Ceci est en particulier le cas avec les dispositifs à transfert de charge utilisés comme mémoires analogiques multiniveaux dans lesquels l'information est stockée sous forme de paquets de charge calibrés qui sont périodiquement régénérés et réinjectés. L'opération de calibration et de recalibration lors de chaque réinjection se réalise avec N comparateurs qui repèrent la position du paquet de charge par rapport à un signal de référence correspondant à N paquets de charge de référence. Habituellement cette opération s'effectue en convertissant les paquets de charge en tension et en utilisant des comparateurs de tension de type connu. De tels comparateurs sont par exemple, du type décrit dans IBM Technical Disclosure Bulletin, Vol. 21, n° 3, Août 1978, P. 1262 et 1263 ou dans IBM Technical Disclosure Bulletin, Vol. 20, n° 5, Octobre 1977, P. 2072-2073.

Pour remédier à cet inconvénient, il serait intéressant d'utiliser un comparateur qui effectue la comparaison au niveau des paquets de charge et évite en conséquence les conversions charge-tension avant comparaison et réciproquement.

On connaît par la demande européenne EP-A-0 147 600, publiée le 10 Juillet 1985 mais bénéficiant d'une priorité du 30 Décembre 1983, un procédé de mesure de la valeur absolue de la différence entre deux paquets de charge et un dispositif pour la mise en oeuvre de ce procédé. Ce procédé consiste à stocker deux paquets de charges sous des capacités MIS adjacentes présentant la même capacité, à mélanger les charges en modifiant le potentiel d'une grille de passage de manière à éliminer la barrière de potentiel entre les capacités puis à rétablir la barrière de potentiel et à mesurer le courant induit par le mélange des charges sur une des électrodes des capacités.

La présente invention utilise une structure similaire à deux capacités séparées par une barrière de potentiel non pas pour mesurer la valeur de la différence entre deux paquets de charge mais pour comparer les deux paquets de charge.

Ainsi, la présente invention a pour objet un comparateur analogique à transfert de charge caractérisé en ce qu'il comporte deux capacités MIS adjacentes pour recevoir respectivement une quantité de charge-signal et une quantité de charge de référence, une grille de passage couplant les deux capacités entre elles, un amplificateur telle que sa caractéristique Vs/Ve comprenne un point d'instabilité lorsque la condition Ve = Vs est remplie, l'entrée de l'amplificateur étant connectée à une des capacités et la sortie à l'autre capacité, un moyen pour permettre, dans une phase précédant la comparaison des charges, le positionnement de la tension d'entrée de l'amplificateur au niveau du point d'instabilité et des moyens pour introduire sous chaque capacité respectivement la charge-signal et la charge de référence.

Les quantités de charge n'étant plus transformées en tension, le comparateur analogique conforme à l'invention présente une très grande sensibilité.

La présente invention concerne aussi divers dispositifs utilisant le comparateur analogique à transfert de charge ci-dessus.

Ainsi la présente invention concerne aussi un convertisseur analogique-numérique ou un recalibrateur utilisant N étages comparateurs tels que décrits ci-dessus.

D'autres caractéristiques et avantages de la présente invention apparaîtront à la lecture de la description de divers modes de réalisation faite avec référence aux dessins ci-annexés dans lesquels:

les figures 1(a) à 1(g) sont respectivement une vue en coupe schématique d'un comparateur conforme à la présente invention et des schémas représentant l'évolution des potentiels de surface lors des différents stades de la comparaison;

la figure 2 représente la caractéristique d'un amplificateur;

la figure 3 est un schéma détaillé du comparateur de figure 1 dans le cas d'une lecture en tension;

la figure 4 est une vue en plan de dessus d'un mode de réalisation d'un convertisseur analogique numérique utilisant des comparateurs conformes à la présente invention;

les figures 5(a) à 5(d) sont respectivement une vue en coupe par V-V de figure 4 et des schémas représentant l'évolution des potentiels de surface lors du fonctionnement du convertisseur, et

la figure 6 est une vue de dessus schématique d'une mémoire analogique multiniveaux comportant des comparateurs conformes à la présente invention utilisés en recalibrateur.

Sur les différentes figures, les mêmes références désignent les mêmes éléments. Toutefois, pour des raisons de clarté, les côtes et proportions des divers éléments n'ont pas été respectées.

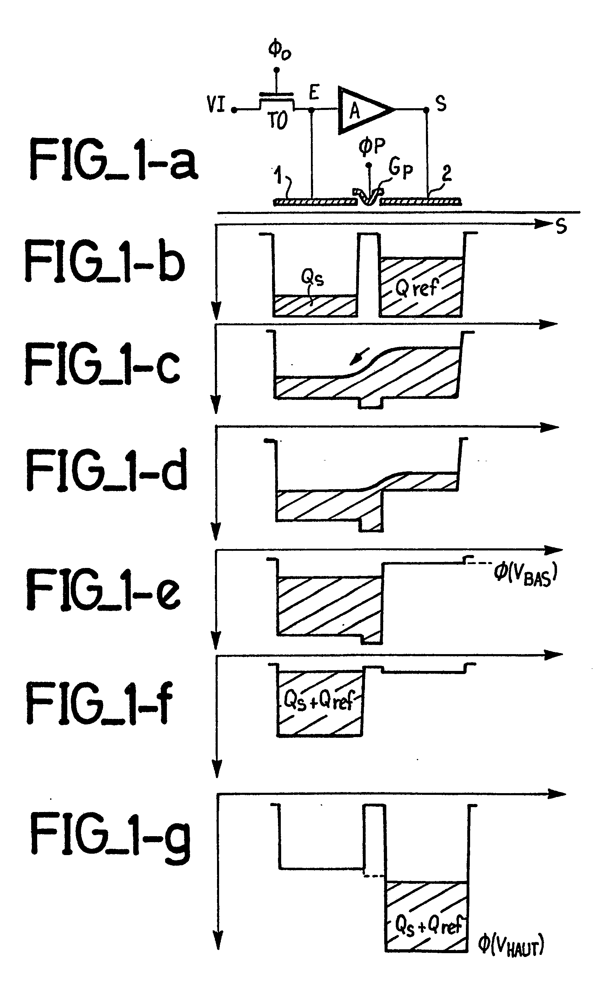

Comme représenté sur la figure 1(a), le comparateur analogique à transfert de charge conforme à la présente invention est constitué principalement par deux capacités MIS 1 et 2 formées de manière connue par le substrat S qui peut être par exemple en silicium de type p, une couche d'isolant par exemple en oxyde de silicium et une grille réalisée par exemple en silicium polycristallin ou en aluminium. Les deux capacités 1 et 2 sont couplées entre elles par une grille de passage $G_P$ reliée a un potentiel périodique $\phi_P$. D'autre part, les grilles des deux capacités MIS 1 et 2 sont reliées respectivement à l'entrée E et à la sortie S d'un amplificateur A. De plus, un transistor MOS $T_0$ est utilisé pour initialiser la comparaison. De manière spécifique, le drain du transistor MOS $T_0$ est connecté à une tension continue $V_I$ choisie de manière à positionner l'amplificateur A au niveau de son point instable, comme cela sera expliqué ci-après. La source du transistor MOS $T_0$ est connectée à l'entrée de l'amplificateur A et la grille du transistor MOS est connectée à un potentiel périodique $\phi_0$ qui rend le transistor $T_0$ passant lors de l'initialisation de la comparaison, c'est-à-dire pendant l'injection des paquets de charges correspondant à la charge signal $Q_S$ et à la charge de référence $Q_{réf}$ respectivement sous les capacités 1 et 2.

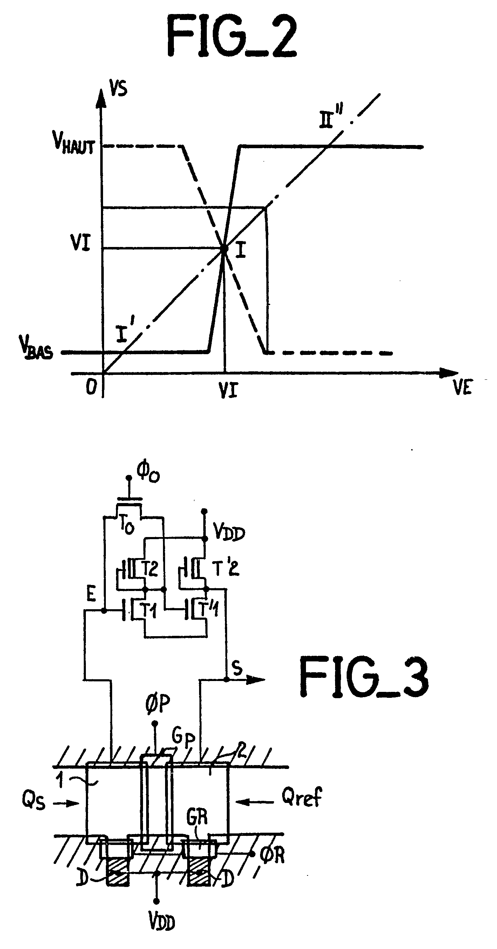

La tension $V_I$ est choisie pour positionner l'amplificateur A à son point instable comme mentionné ci-dessus. En effet, pour obtenir sous les capacités MOS 1 et 2 des puits de potentiel identiques, il est nécessaire que la tension d'entrée de l'amplificateur appliquée sur la grille de la capacité 1 soit égale à la tension de sortie de cet amplificateur appliquée sur la grille de la capacité 2. D'autre part, pour pouvoir détecter une variation de la tension de sortie par rapport à la tension d'entrée, il est nécessaire de se placer au niveau du point instable de la caractéristique de l'amplificateur illustrée par la courbe en trait plein représentée à la figure 2. En effet la courbe en trait plein représente la caractéristique $V_S$ (tension de sortie) en fonction de $V_E$ (tension d'entrée) d'un amplificateur. Si l'on trace la première bissectrice, on voit que cette bissectrice coupe la caractéristique en trois points référencés I', I, I''. Pour ces trois points $V_S = V_E$. Cependant si l'on se place au point I correspondant à la tension $V_I$, on s'aperçoit que, pour un léger déséquilibre de la tension $V_S$ par rapport à $V_E$, il y a basculement vers la valeur de $V_S$ correspondant à $V_{haut}$ ou vers la valeur de $V_S$ correspondant à $V_{bas}$ suivant le sens du déséquilibre. Ainsi, pour réaliser la comparaison de deux quantités de charge stockées sous les capacités 1 et 2, on utilise cette possibilité de basculement autour du point instable I, comme cela sera expliqué de manière plus détaillée avec référence aux figures 1(b) à 1(g).

Comme représenté sur la figure 1(b), lors de l'initialisation de la comparaison, la tension $\phi_0$ est au niveau haut de façon à imposer la tension $V_I$ à l'entrée de l'amplificateur A. Cette tension $V_I$ étant celle pour laquelle l'amplificateur délivre une tension de sortie égale à celle d'entrée, la tension $V_I$ est aussi imposée à la sortie de l'amplificateur. Il en résulte que les puits de potentiel sous les capacités 1 et 2 sont égaux. La grille $\phi_P$ étant au niveau bas, la charge signal $Q_S$ est introduite sous la grille de la capacité 1 et une charge de référence $Q_{réf}$ sous la grille de la capacité 2 en utilisant tout dispositif d'introduction de charge de type connu. Le dispositif d'introduction de charges peut être constitué par une simple grille de passage lorsque le comparateur est connecté à un dispositif à transfert de charge ou par un dispositif réalisant une conversion tension-charge constitué principalement par une diode d'injection lorsque le signal est sous forme d'une tension.

Lorsque l'initialisation est terminée, le potentiel $\phi_0$ est alors ramené au niveau bas de manière que le potentiel au point E appliqué sur la grille de la capacité 1 redevienne flottant. Comme représenté sur la figure 1(c), le potentiel $\phi_P$ de la grille $G_P$ est porté au niveau haut, à savoir à un niveau supérieur au niveau créé par $V_I$, de sorte que les charges peuvent s'écouler entre les deux capacités adjacentes. Le puits de potentiel le plus rempli s'écoule alors dans le puits voisin.

Dans le mode de réalisation représenté, on a supposé par exemple $Q_{réf}$ supérieure à $Q_S$. Les charges s'écoulent donc sous la capacité 1, ce qui abaisse son potentiel. L'amplificateur A transmet cette variation de potentiel sur la grille de la capacité 2. Il en résulte que le potentiel de surface sous la grille de la capacité 2 décroît rapidement jusqu'à atteindre le niveau $\phi$ ($V_{bas}$) comme représenté sur les figures 1(d) et 1(e).

Dans cette condition, après avoir ramené le potentiel $\phi_P$ au niveau bas, l'ensemble des charges $Q_{réf} + Q_S$ se retrouve du côté de la charge la plus petite, à savoir sous la capacité 1 comme représenté sur la figure 1(f).

Si au lieu de prendre $Q_{réf}$ supérieure à $Q_S$, on prend comme condition $Q_S$ supérieure à $Q_{réf}$, les charges s'écoulent de la capacité 1 vers la capacité 2, ce qui élève le potentiel de la capacité 1 et fait basculer l'amplificateur A vers le niveau $V_{haut}$. Dans ce cas, l'ensemble des charges $Q_S + Q_{réf}$ se retrouve sous la capacité 2 à savoir du côté de la charge la plus petite comme représenté sur la figure 1(g).

En conséquence suivant que la charge signal $Q_S$ est inférieure ou supérieure à la charge de référence $Q_{réf}$, l'ensemble des charges $Q_S + Q_{réf}$ se retrouve soit sous la capacité 1 soit sous la capacité 2 et en lisant en charge ou en tension l'état final du comparateur, on obtient donc le résultat de la comparaison.

En effet l'état final du comparateur peut être lu de deux façons:

— soit en tension: dans ce cas le point S en sortie de l'amplificateur est au niveau haut si $Q_{réf}$ inférieure à $Q_S$ et le point S est au niveau bas si $Q_{réf}$ supérieure à $Q_S$;

— soit en charge: dans ce cas l'ensemble des charges $Q_S + Q_{réf}$ se retrouve sous la grille de la capacité présentant la plus petite charge initiale.

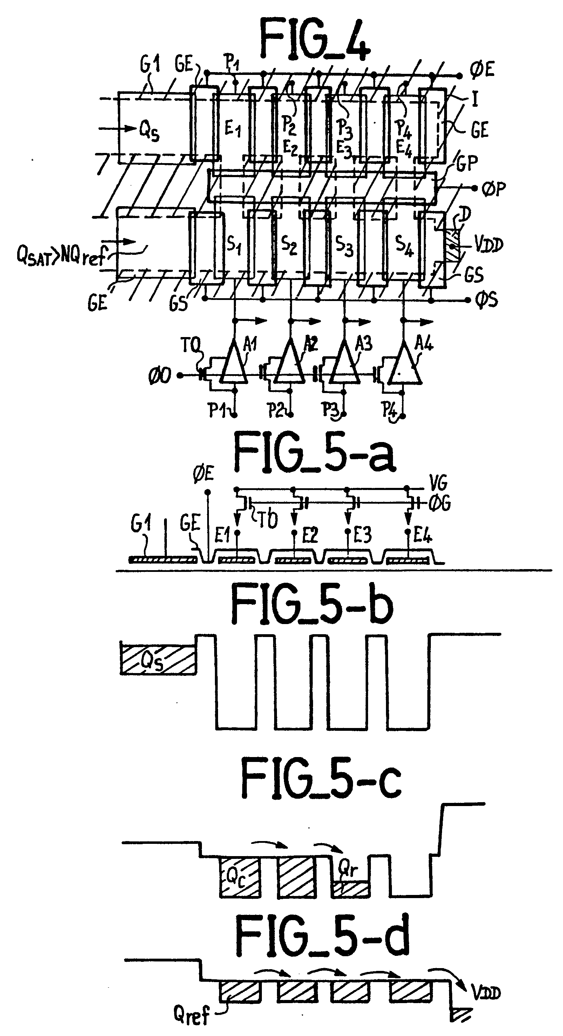

On décrira maintenant en se référant plus particulièrement à la figure 3, un mode de réalisation d'un amplificateur pouvant être utilisé dans la présente invention pour obtenir la tension $V_I$. Dans ce cas, l'amplificateur A est réalisé à l'aide de deux inverseurs montés en série. De manière plus spécifique, chaque inverseur est constitué par un transistor MOS $T_1$, $T'_1$ dont la grille reçoit le signal d'entrée, et dont le drain donne le signal de sortie. D'autre part, le drain est connecté par l'intermédiaire d'une résistance de charge à une tension continue $V_{DD}$. Cette résistance de charge est constituée dans le mode de réalisation représenté, par un transistor MOS $T_2$, $T'_2$ à dépletion dont la grille est bouclée sur la source. Si les deux inverseurs $T_1$, $T_2$ et $T'_1$, $T'_2$ sont identiques, la polarisation initiale à la tension $V_I$ s'obtient simplement en court-circuitant le premier inverseur $T_1$, $T_2$ par le transistor MOS $T_0$, à savoir en connectant le drain et la source du transistor MOS $T_0$ respectivement a l'entrée et à la sortie du premier inverseur $T_1$, $T_2$.

En effet, on voit à l'aide de la caractéristique de transfert de l'inverseur représentée en pointillés sur la figure 2 que l'inverseur court-circuité n'a qu'un point de repos I qui délivre la tension $V_I$ à l'entrée et à la sortie de l'amplificateur.

D'autre part, dans le mode de réalisation du comparateur de la figure 3, la lecture de l'état final se fait en tension et les charges doivent être évacuées avant de recommencer une comparaison. Pour réaliser cette évacuation, on prévoit près de chaque capacité 1 et 2 und dispositif d'évacuation des charges constitué, pour chaque capacité, par une grille $G_R$ reliée à un potentiel $\phi_R$ et par une diode D polarisée en inverse par une tension continue $V_{DD}$. Pendant toute la comparaison le potentiel $\phi_R$ est au niveau bas pour empêcher le passage des charges vers les diodes D, mais à la fin de la comparaison le potentiel $\phi_R$ est porté à un niveau haut, ce qui permet d'évacuer les charges se trouvant soit sous la capacité 1 soit sous la capacité 2 vers la diode correspondante.

On décrira maintenant avec référence aux figures 4 et 5 un convertisseur analogique numérique ou un calibrateur de charge utilisant un comparateur du type représenté aux figures 1 à 3.

Comme expliqué de manière plus détaillée ci-après, suivant le type de lecture utilisé, le même dispositif de base peut être utilisé soit comme convertisseur soit comme calibrateur. Aussi, dans la description ci-après, on parlera principalement de convertisseur analogique-numérique.

Pour simplifier les figures le convertisseur analogique numérique ne comporte que quatre niveaux, mais il est évident pour l'homme de l'art que ce convertisseur peut comporter facilement un plus grand nombre de niveaux.

Le convertisseur analogique numérique représenté à la figure 4 est constitué par la mise en parallèle de quatre comparateurs analogiques à transfert de charge du type décrit ci-dessus. Chaque comparateur est constitué respectivement des capacités $E_1$, $S_1$; $E_2$, $S_2$; $E_3$, $S_3$; $E_4$, $S_4$, de la grille de passage $G_P$ et de l'amplificateur $A_1$, $A_2$, $A_3$, $A_4$, court-circuité par le transistor MOS $T_O$ relié à un potentiel $\phi_O$. Comme représenté sur la figure 4, les différents étages comparateurs sont couplés entre eux au niveau des capacités par des grilles de passage $G_E$ et $G_S$ portées respectivement à des potentiels $\phi_E$ et $\phi_S$. Les grilles de passage $G_E$ et $G_S$ assurent l'écoulement des charges respectivement dans le canal des capacités $E_1$, $E_2$, $E_3$, $E_4$ et dans le canal des capacités $S_1$, $S_2$, $S_3$, $S_4$. Ces canaux sont délimités par des barrières d'isolement I représentées par des hachures sur la figure 4. D'autre part, des capacités de stockage de charge $G_1$ et $G_2$ permettant de stocker respectivement la charge signal et une charge supérieure à N fois la charge de référence sont prévues en amont de chaque canal correspondant aux capacités $E_1$, $E_2$, $E_3$, $E_4$ et aux capacités $S_1$, $S_2$, $S_3$, $S_4$. De plus, une diode D' d'évacuation des charges reliée à la tension continue $V_{DD}$ est prévue en aval de la capacité $S_4$ recevant la charge de référence du dernier étage comparateur. Le rôle de cette diode D' sera expliqué en détail ci-après.

On expliquera maintenant le fonctionnement du comparateur en se référant plus particulièrement aux figures 5(a) à 5(d). Tout d'abord la charge $Q_S$ à comparer qui se trouve sous la grille de stockage $G_1$ est introduite dans le canal des capacités $E_1$, $E_2$, $E_3$, $E_4$ et des grilles $G_E$. Pour cela le potentiel $\phi_E$ appliqué sur les grilles $G_E$ qui se trouvait à un niveau bas comme représenté sur la figure 5(b), passe à un niveau haut comme représenté sur la figure 5(c). De ce fait, la charge $Q_S$ se répand sous les grilles des capacités $E_1$, $E_2$, $E_3$, $E_4$ dont la capacité de stockage maximum $Q_C$ est fixée par le niveau haut de $\phi_E$. La charge $Q_C$ correspond en fait à la charge unitaire avec laquelle la charge-signal $Q_S$ doit être calibrée. Dans le mode de réalisation représenté, la charge $Q_S$

a rempli les puits de potentiel sous $E_1$ et $E_2$ mais n'a rempli le puit de potentiel sous $E_3$ qu'avec une charge $Q_r$ inférieure à la charge $Q_C$ comme représenté à la figure 5(c). En même temps, une charge $Q_{SAT}$ qui est choisie pour être supérieure à N $Q_{réf}$, à savoir à 4 $Q_{réf}$ dans le node de réalisation représenté, est introduite dans le canal des capacités $S_1$, $S_2$, $S_3$, $S_4$. La charge $Q_{SAT}$ se répand dans les puits de potentiel créés sous les grilles des capacités $S_1$, $S_2$, $S_3$, $S_4$ dont la capacité de stockage maximum $Q_{réf}$ est fixée par le niveau haut du potentiel $\phi_S$ appliqué sur les grilles $G_S$. De préférence, on choisit la capacité de stockage maximum $Q_{réf}$ de telle sorte que la charge $Q_C-Q_{réf}$ soit supérieure à 2 $Q_{MIN}$, $Q_{MIN}$ étant le seuil de sensibilité commun à tous les comparateurs. La charge $Q_{SAT}$ remplit tous les puits de potentiel sous les grilles des capacités $S_1$, $S_2$, $S_3$, $S_4$ et l'excédent de charge est évacué à l'extrémité des étages comparateurs vers la diode D'. Pendant cette opération de remplissage des puits de potentiel sous les grilles des capacités $E_1$, $E_2$, $E_3$, $E_4$ et $S_1$, $S_2$, $S_3$, $S_4$, le potentiel $\phi_P$ appliqué sur la grille $G_P$ est au niveau bas et les grilles des capacités $E_1$, $E_2$, $E_3$, $E_4$, $S_1$, $S_2$, $S_3$, $S_4$, reçoivent toutes la tension $V_I$ commune aux comparateurs en positionnant la phase $\phi_O$ au niveau haut. La tension $V_I$ est supérieure aux potentiels $\phi_E$ et $\phi_S$, ladite tension et les potentiels étant choisis de manière à réaliser des charges $Q_C$ et $Q_{réf}$ bien définies.

On suppose que les amplificateurs $A_1$, $A_2$, $A_3$, $A_4$ qui peuvent être constitués par deux inverseurs en série comme dans le mode de réalisation de la figure 3, ne présentent aucune dispersion sur les niveaux $V_I$. Dans le cas contraire, il est possible pendant cette opération de remplissage de les déconnecter des grilles des capacités $E_1$, $E_2$, $E_3$, $E_4$ et $S_1$, $S_2$, $S_3$, $S_4$ et d'appliquer sur ces grilles une tension commune $V_G$ par l'intermédiaire de transistors MOS $T'_O$ polarisés en triode par le potentiel $\phi_G$ comme représenté sur la figure 5(a). En effet, pour que le convertisseur analogique numérique fonctionne correctement, il est important de réaliser des charges $Q_C$ et $Q_{réf}$ homogènes d'un étage à l'autre.

Lorsque l'opération de remplissage est achevée, les potentiels $\phi_E$ et $\phi_S$ appliqués sur les grilles $G_E$ et $G_S$ sont portés à un niveau bas ce qui isole les capacités $E_1$, $E_2$, $E_3$, $E_4$ et respectivement les capacités $S_1$, $S_2$, $S_3$, $S_4$, entre elles. Ensuite les points $P_1$, $P_2$, $P_3$, $P_4$ sont rendus flottant. Le potentiel $\phi_P$ est alors porté au niveau haut et les quatre comparaisons s'effectuent en parallèle au niveau de chaque étage comparateur de la même manière que pour le comparateur des figures 1 à 3.

Dans ce cas la lecture du résultat peut aussi s'effectuer de deux façons: soit en tension, soit en charge.

La lecture en tension est réalisée par une lecture des niveaux de sortie des amplificateurs. Les n premiers comparateurs sont au niveau «l» à savoir les deux premiers comparateurs dans le mode de réalisation représenté, tandis que les autres étages comparateurs sont au niveau «O». Un codage binaire est alors possible à partir de ces n niveaux.

Pour la lecture en charge, on obtient pour l'ensemble des n premiers puits $S_1$, $S_2$, ... $S_n$, la charge n

$(Q_C + Q_{réf})$, la charge résiduelle $Q_r + Q_{réf}$ se trouvant dans le $(n+1)^{ième}$ puits E. Cette charge n $(Q_C + Q_{réf})$ peut être récupérée pour fournir la charge recalibrée lorsque le convertisseur est utilisé de préférence comme calibrateur. Si par exemple $Q_{réf} = Q_C/m$, on obtient en sortie une charge égale $n \cdot \dfrac{m+1}{m} Q_C$

qu'il suffit de partager en deux parties $n \dfrac{Q_C}{m}$ et n $Q_C$ pour obtenir la charge recalibrée n $Q_C$.

Le partage de charge peut se faire dans un canal CCD (pour Charge Coupled Device en langue anglaise) comme décrit dans le brevet français 77.28737 publié sous le n° FR-A-2 404 281 ou par division capacitive.

L'avantage d'un partage dans un canal CCD est qu'on obtient directement une charge réinjectable.

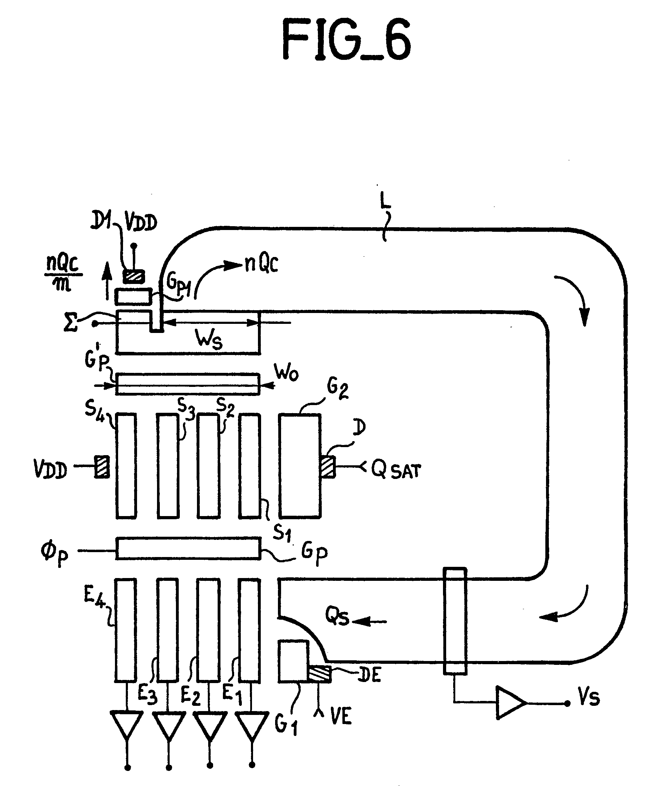

On décrira maintenant en se référant plus particulièrement à la figure 6, une mémoire multiniveaux à transfert de charge utilisant des comparateurs conformes à la présente invention associés en recalibrateur.

La mémoire L est constituée par une ligne à retard réalisée par exemple par un registre à transfert de charge de type CCD. Cette ligne à retard est bouclée sur elle même à travers le recalibrateur. Le recalibrateur est constitué comme le convertisseur analogique numérique des figures 5 et 4 par N étages comparateurs associés en parallèle. Dans ce cas, l'injection des charges dans le recalibrateur est réalisée soit à partir de la mémoire soit à partir d'un dispositif d'injection externe et les charges recalibrées sont injectées directement dans la mémoire.

En conséquence, la sortie de la ligne à retard est reliée par l'intermédiaire d'une grille de passage non représentée à la première capacité $E_1$ du recalibrateur.

D'autre part, la lecture des étages comparateurs étant effectuée en charge, les capacités $S_1$, $S_2$, $S_3$, $S_4$ des étages comparateurs sont couplées par l'intermédiaire d'une grille de passage $G'_P$ et d'une électrode $\Sigma$ à l'entrée de la ligne à retard pour lui injecter une charge calibrée n $Q_C$.

D'autre part, pour enregistrer le signal à mémoriser, celui-ci est injecté par l'intermédiaire de la diode $D_E$ sous une grille de stockage $G_1$ permettant l'injection de charge dans le canal des capacités $E_1$, $E_2$, $E_3$, $E_4$, comme décrit pour le convertisseur de la figure 4.

De plus, une grille de passage $G_{P1}$ et une diode $D_1$ d'évacuation des charges sont positionnées en aval de l'électrode $\Sigma$ pour permettre l'évacuation de la charge résiduelle non calibrée comme cela sera expliqué ci-après.

Avec ce type de mémoire, les charges $Q_S$ sont injectées une première fois par l'intermédiaire de la diode $D_E$ et de la grille $G_1$ sous les grilles des capacités $E_1$, $E_2$, $E_3$, $E_4$ du calibrateur où elles sont codées en série comme cela a été expliqué avec référence au convertisseur des figures 4 et 5.

De ce fait, la charge codée $n \cdot \dfrac{m+1}{m} Q_C$ est disponible sous les grilles des capacités $S_1$, $S_2$, $S_3$, $S_4$. Le contenu des puits de potentiel sous les grilles des capacités $S_1$, $S_2$, $S_3$, $S_4$ est sommé en parallèle sous une électrode $\Sigma$ dont le canal est partagé de telle sorte que la largeur utile soit égale à $W_s = W_o \dfrac{m}{m+1}$,

$W_o$ étant la largeur initiale de la grille $G'_P$ comme représenté sur la figure 6.

La charge n $Q_C$ est alors disponible à l'entrée de la ligne à retard L tandis que la charge n $Q_C/m$ est évacuée vers la diode $D_1$ d'évacuation des charges de manière connue. La charge n $Q_C$ est ensuite recalibrée à chaque passage et le signal parcourant la ligne à retard peut être lu en permanence sur une grille flottante G disposée en un endroit quelconque de la ligne et reliée à un amplificateur A'.

Il est évident pour l'homme de l'art que de nombreuses modifications peuvent être apportées aux modes de réalisation décrits ci-dessus sans sortir du cadre de la présente invention.

## Revendications

1. Comparateur analogique à transfert de charge, caractérisé en ce qu'il comporte deux capacités MIS (1, 2) adjacentes pour recevoir respectivement une quantité de charge-signal et une quantité de charge de référence, une grille de passage ($G_P$) couplant les deux capacités entre elles, un amplificateur (A) telle que sa caractéristique $V_S/V_E$ (tension de sortie/tension d'entrée) comprenne un point d'instabilité lorsque la condition $V_E = V_S$ est remplie, l'entrée de l'amplificateur étant connectée à une des capacités et la sortie à l'autre capacité, un moyen ($T_O$) pour permettre, dans une phase précédent la comparaison des charges, le positionnement de la tension d'entrée de l'amplificateur au niveau du point d'instabilité et des moyens pour introduire sous chaque capacité respectivement soit la charge-signal, soit la charge de référence.

2. Comparateur selon la revendication 1, caractérisé en ce le moyen pour permettre, dans une phase précédant la comparaison des charges, le positionnement de la tension d'entrée de l'amplificateur au niveau du point d'instabilité est constitué par un transistor MOS ($T_O$) dont le drain est connecté à une tension ($V_I$) continue positionnant l'amplificateur au niveau du point instable de la caractéristique $V_S/V_E$, lorsque $V_S = V_E$, dont la porte est connectée à un potentiel périodique ($\phi_O$) rendant le transistor passant lors de l'introduction de la charge-signal et de la charge de référence dans les capacités et dont la source est reliée à l'entrée de l'amplificateur.

3. Comparateur selon l'une quelconque des revendications 1 et 2, caractérisé en ce que la grille de passage ($G_P$) est reliée à un potentiel périodique ($\phi_P$) mettant en communication les deux capacités après introduction des charges.

4. Comparateur selon l'une quelconque des revendications 1 à 3, caractérisé en ce que l'amplificateur (A) est constitué par deux inverseurs ($T_1$, $T_2$, $T'_1$, $T'_2$) montés en série.

5. Comparateur selon les revendications 2 et 4, caractérisé en ce que le drain du transistor MOS ($T_O$) est connecté à la sortie du premier inverseur ($T_1$, $T'_1$).

6. Comparateur selon l'une quelconque des revendications 1 à 5, caractérisé en ce qu'il comporte de plus des moyens de lecture en charge du résultat de la comparaison.

7. Comparateur selon l'une quelconque des revendications 1 à 5, caractérisé en ce qu'il comporte de plus un moyen (S) de lecture en tension du résultat de la comparaison.

8. Comparateur selon la revendication 7, caractérisé en ce qu'il comporte, au niveau de chaque capacité, un moyen d'évacuation des charges (D, $G_R$) pour évacuer les charges restant sous les capacités après la lecture en tension du résultat de la comparaison.

9. Comparateur selon la revendication 8, caractérisé en ce que le moyen d'évacuation des charges est constitué par une grille de passage ($G_R$) adjacente à chaque capacité et reliée à un potentiel périodique ($\phi_R$) porté au niveau haut après la lecture du résultat de la comparaison et une diode (D) polarisée en inverse par une tension continue ($V_{DD}$).

10. Convertisseur analogique-numérique ou calibrateur, caractérisé en ce qu'il comporte N étages comparateurs selon l'une quelconque des revendications 1 à 9 montés en parallèle, les capacités ($E_1$, $E_2$, $E_3$, $E_4$) des N comparateurs correspondant à la capacité recevant une quantité de charge-signal étant couplées entre elles et les capacités ($S_1$, $S_2$, $S_3$, $S_4$) correspondant à la capacité recevant une quantité de charge de référence étant couplées entre elles respectivement par des grilles de passage ($G_E$, $G_S$) constituant les moyens d'introduction des charges dans chaque étage et en ce qu'il comporte des moyens ($G_1$, $G_2$) pour injecter dans le premier étage comparateur la charge-signal et une charge au moins égale à N fois la charge de référence.

11. Convertisseur analogique-numérique ou calibrateur selon la revendication 10, caractérisé en ce qu'il comporte un dispositif (D') d'évacuation des charges prévue en aval de la capacité ($S_4$) de stockage de la charge de référence du dernier étage comparateur.

12. Convertisseur analogique-numérique ou calibrateur selon la revendication 11, caractérisé en ce que chaque grille de passage ($G_E$, $G_S$) est reliée à un potentiel périodique ($\phi_E$, $\phi_S$) dont le niveau haut défini respectivement la valeur de la charge de calibration ($Q_C$) et la valeur de la charge de référence ($Q_{réf}$).

13. Convertisseur analogique-numérique ou calibrateur selon la revendication 13, caractérisé en ce que la charge de calibration ($Q_C$) et la charge de référence ($Q_{réf}$) sont choisies pour que la charge ($Q_C$-$Q_{réf}$) soit supérieure à 2 $Q_{MIN}$, $Q_{MIN}$ étant le seuil de sensibilité commun à tous les étages comparateurs.

14. Calibrateur selon la partie correspondant au calibrateur de l'une quelconque des revendications 10 à 13, caractérisé en ce que, dans le cas d'une lecture en charge, il comporte des moyens permettant de partager la charge lue en deux parties de manière à obtenir une charge recalibrée.

**Patentansprüche**

1. Analoger Ladungsüberführungs-Komparator, dadurch gekennzeichnet, dass er zwei benachbarte MIS-Kapazitäten (1, 2) aufweist, wovon die eine eine Signal-Ladungsmenge und die andere eine Referenz-Ladungsmenge empfängt, wobei eine Überleitungs-elektrode ($G_P$), die beiden Kapazitäten miteinander koppelt, einen Verstärker (A) aufweist, der so ausgebildet ist, dass seine Charakteristik $V_S/V_E$ (Aus-gangsspannung/Eingangsspannung) einen Instabili-tätspunkt aufweist, wenn die Bedingung $V_E = V_S$ erfüllt ist, wobei der Verstärkereingang mit einer der Kapazitäten und der Ausgang mit der anderen Kapazität verbunden ist, ein Mittel ($T_O$) aufweist, um in einer dem Ladungsvergleich vorausgehenden Phase die Einstellung der Eingangsspannung des Verstärkers auf den Pegel des Instabilitätspunktes zu ermöglichen, sowie Mittel aufweist, um unter die betreffende Kapazität die Signal-Ladung bzw. die Referenz-Ladung einzuführen.

2. Komparator nach Anspruch 1, dadurch gekennzeichnet, dass das Mittel, welches die Einstellung der Eingangsspannung des Verstärkers auf den Pegel des Instabilitätspunktes in einer dem Ladungsvergleich vorausgehenden Phase ermöglicht, aus ei-nem MOS-Transistor ($T_O$) besteht, dessen Drain-elektrode mit einer Gleichspannung ($V_1$) verbunden ist, welche den Verstärker auf den Pegel des Insta-bilitätspunktes der $V_S/V_E$-Charakteristik einstellt, wenn $V_S = V_E$, dessen Gate mit einer periodischen Spannung ($\phi_O$) verbunden ist, die den Transistor beim Einführen der Signal-Ladung und der Referenz-Ladung in die Kapazitäten leitend macht, und dessen Source mit dem Verstärkereingang verbunden ist.

3. Komparator nach einem der Ansprüche 1 oder 2, dadurch gekennzeichnet, dass die Überleitungs-elektrode ($G_P$) mit einer periodischen Spannung ($\phi_P$) verbunden ist, welche die beiden Kapazitäten nach der Ladungseinspeisung miteinander verbindet.

4. Komparator nach einem der Ansprüche 1 bis 3, dadurch gekennzeichnet, dass der Verstärker (A) aus zwei in Reihe geschalteten Umschaltern ($T_1$, $T_2$, $T'_1$, $T'_2$) besteht.

5. Komparator nach den Ansprüchen 2 und 4, da-durch gekennzeichnet, dass die Drainelektrode des MOS-Transistors ($T_O$) mit dem Ausgang des ersten Umschalters ($T_1$, $T_2$) verbunden ist.

6. Komparator nach einem der Ansprüche 1 bis 5, dadurch gekennzeichnet, dass er ferner Mittel zum Auslesen des Vergleichsergebnisses über die Ladung aufweist.

7. Komparator nach einem der Ansprüche 1 bis 5, dadurch gekennzeichnet, dass er ferner ein Mittel (S) zum Auslesen des Vergleichsergebnisses über die Spannung aufweist.

8. Komparator nach Anspruch 7, dadurch gekennzeichnet, dass er an jeder Kapazität, ein Ladungsabführungsmittel (D, $G_R$) zum Abladen der Ladungen aufweist, die nach dem Auslesen des Vergleichsergebnisses über die Spannung unter den Kapazitäten verbleiben.

9. Komparator nach Anspruch 8, dadurch gekennzeichnet, dass das Ladungsabführungsmittel aus einer Überleitungselektrode ($G_R$), die jeder Kapazität benachbart ist und an eine periodische Spannung ($\phi_R$), die nach dem Auslesen des Vergleichsergebnisses auf hohen Pegel gebracht wird, angeschlossen ist, sowie aus einer durch eine Gleichspannung ($V_{DD}$) in Sperrichtung gepolten Diode besteht.

10. Analog/Digital-Umsetzer oder Kalibrator, dadurch gekennzeichnet, dass er N Komparatorstufen nach einem der Ansprüche 1 bis 9 aufweist, welche parallel geschaltet sind, wobei die Kapazitäten ($E_1$, $E_2$, $E_3$, $E_4$) der N Komparatoren, die derjenigen Kapazität entsprechen, die eine Signalladungsmenge empfängt, miteinander gekoppelt sind, und die Kapazitäten ($S_1$, $S_2$, $S_3$, $S_4$), die derjenigen Kapazität entsprechen, die eine Referenzladungsmenge empfängt, miteinander jeweils über eine Überleitungselektrode ($G_E$, $G_S$) gekoppelt sind, welche die Ladungseinspeisungsmittel in jeder Stufe bilden, und dass er Mittel ($G_1$, $G_2$) aufweist, um in die erste Komparatorstufe die Signalladung sowie eine Ladung einzuspeisen, die wenigstens das N-fache der Referenzladung ist.

11. Analog/Digital-Umsetzer oder Kalibrator nach Anspruch 10, dadurch gekennzeichnet, dass er eine Ladungsabführungsvorrichtung (D') aufweist, welche hinter der Kapazität ($S_4$) vorgesehen ist, welche die Referenzladung der letzten Komparatorstufe speichert.

12. Analog/Digital-Umsetzer oder Kalibrator nach Anspruch 11, dadurch gekennzeichnet, dass jede Überleitungselektrode ($G_E$, $G_S$) mit jeweils einer periodischen Spannung ($\phi_E$, $\phi_S$) verbunden ist, deren hoher Pegel den Wert der Kalibrierladung ($Q_C$) bzw. den Wert der Referenzladung ($Q_{réf}$) bestimmt.

13. Analog/Digital-Umsetzer oder Kalibrator nach Anspruch 12, dadurch gekennzeichnet, dass die Kalibrierladung ($Q_C$) und die Referenzladung ($Q_{réf}$) so gewählt sind, dass die Ladung ($Q_C$-$Q_{réf}$) grösser ist als 2 $Q_{MIN}$, wobei $Q_{MIN}$ die gemeinsame Empfindlichkeitsschwelle aller Komparatorstufen ist.

14. Kalibrator nach dem entsprechenden Teil eines der Ansprüche 10 bis 13, dadurch gekennzeichnet, dass im Falle eines Auslesens über die Ladung, er Mittel aufweist, die die Teilung der ausgelesenen Ladung in zwei Teile ermöglichen, so dass man eine neukalibrierte Ladung erhält.

**Claims**

1. A charge transfer analog comparator characterized in that it comprises two adjacent MIS capacitors (1 and 2) to respectively receive a signal charge and a quantity of reference charge, a passage grid ($G_P$) coupling the two capacitors, an amplifier (A) such that its $V_S/V_E$ (output voltage/input voltage) function has a point of instability when the condition $V_E = V_S$ is fulfilled, the input of the amplifier being connected with one of the capacitors and the output with the other capacitor, a means ($T_O$) to permit, on comparison of the charges during the preceding phase, the setting of the input voltage of the amplifier at the level of the point of instability, and means for supplying each capacitor, respectively, either with the signal charge or the reference charge.

2. The comparator as claimec in claim 1 characterized in that the means for permitting, in a phase preceding the comparison of charges, the setting of the input voltage of the amplifier at the point of instability is constituted by an MOS transistor ($T_O$) whose drain is connected with a direct voltage ($V_1$) setting the amplifier at the instable point of the $V_S/V_E$ function when $V_S = V_E$ whose gate is connected with a periodic potential ($\phi_O$) rendering the transistor conducting at the time of the supply of the signal charge and of the reference charge to the capacitors and whose source is connected with the input of the amplifier.

3. The comparator as claimed in either of the claims 1 and 2 characterized in that the passage grid ($G_P$) is connected with a periodic potential ($\phi_P$) putting the two capacitors in communication with each other after the introduction of the charges.

4. The comparator as claimed in any one of the claims 1 to 3 characterized in that the amplifier (A) is constituted by two inverters ($T_1$, $T_2$, $T'_1$, $T'_2$) placed in series.

5. The comparator as claimed in claims 2 and 4 characterized in that the drain of the MOS transistor ($T_O$) is connected with the output of the first inverter ($T_1$ and $T_2$).

6. The comparator as claimed in any one of the claims 1 to 5 characterized in that it furthermore comprises voltage reading means for the result of the comparison.

7. The comparator as claimed in any one of the claims 1 to 5 characterized in that it furthermore comprises a charge reading means (S) for the result of the comparison.

8. The comparator as claimed in claim 7 characterized in that at the level of each capacitor it comprises a means (D and $G_R$) for removing the charges remaining at the capacitors after the voltage reading as the result of the comparison.

9. The comparator as claimed in claim 8 characterized in that the means for removing the charges is constituted by a passage grid ($G_R$) adjacent to the capacitor and connected with a periodic potential ($\phi_R$) transferred to a higher level after the reading of the result of comparison and a diode (D) which is inversely polarized by a direct voltage ($V_{DD}$).

10. An analog-digital converter or calibrator characterized in that it comprises N comparing stages in accordance with any one of the claims 1 to 9 placed in parallel with each other, the capacitors ($E_1$, $E_2$, $E_3$ and $E_4$) of the N comparators corresponding to the capacitor receiving a quantity of signal charge and the capacitors ($S_1$, $S_2$, $S_3$ and $S_4$) corresponding to the capacitor receiving a reference quantity of charge being respectively coupled together by passage grids ($G_E$ and $G_S$) constituting means for feeding charges in each stage and in that it comprises means ($G_1$ and $G_2$) for feeding the signal charge to the first comparator and a charge at least equal to N times the reference charge.

11. The analog-digital converter or calibrator as claimed in claim 10 characterized in that it comprises a device (D') for removing charges placed downstream from the capacitor ($S_4$) for holding the reference charge of the last comparator stage.

12. The analog-digital converter or calibrator as claimed in claim 11 characterized in that each passage grid ($G_E$ and $G_S$) is connected respectively with a periodic potential ($\phi_E$ and $\phi_S$) whose high level respectively defines the value of the calibration charge ($Q_C$) and the value of the reference charge ($Q_{ref}$).

13. The analog-digital converter or calibrator as claimed in claim 12 characterized in that the calibration charge ($Q_C$) and the reference charge ($Q_{ref}$) are selected so that the charge ($Q_C-Q_{ref}$) is greater than 2 $Q_{MIN}$, $Q_{MIN}$ being the threshold of sensitivity common to all the comparator stages.

14. The analog-digital converter or calibrator as claimed in any one of the claims 10 to 13 characterized in that in the case of reading a charge it comprises means making it possible to share the charge read in two parts, in such a manner as to obtain a recalibrated charge.

FIG_1-a

FIG_1-b

FIG_1-c

FIG_1-d

FIG_1-e

FIG_1-f

FIG_1-g

# FIG_2

# FIG_3

# FIG_4

# FIG_5-a

# FIG_5-b

# FIG_5-c

# FIG_5-d

# FIG_6